# EUROPÄISCHE PATENTANMELDUNG

(11) **EP 2 453 483 A2**
(43) Veröffentlichungstag der Anmeldung: **16.05.2012**
(21) Anmeldenummer: 11186519.2
(22) Anmeldetag: 25.10.2011
(51) Int. Cl.: H01L 31/0216

(54) **Solarzelle und Solarzellenherstellungsverfahren**

(30) Priorität: 04.11.2010 DE 102010060339
(71) Anmelder: Q-Cells SE, 06766 Bitterfeld-Wolfen (DE)
(72) Erfinder: Scherff, Maximilian, 44369 Dortmund (DE); Mohr, Andreas, 04177 Leipzig (DE); Seguin, Robert, 12109 Berlin (DE); Hofmann, Matthias, 04105 Leipzig (DE); Stekolnikov, Andrey, 04105 Leipzig (DE)
(74) Vertreter: Bakhtyari, Arash

(57) **Zusammenfassung**

Die Erfindung betrifft eine Solarzelle mit einem Halbleitersubstrat (1), einer auf einer lichtabgewandten Rückseitenoberfläche (11) des Halbleitersubstrats (1) angeordneten Rückseitenpassivierschicht (2), einer auf der Rückseitenpassivierschicht (2) angeordneten Deckschicht (3) und einer auf der Deckschicht (3) angeordneten Metallisierungsschicht (4), dadurch gekennzeichnet, dass die Deckschicht (3) einen der Rückseitenpassivierschicht (2) zugewandten Schutzschichtabschnitt (31) und einen der Metallisierungsschicht (4) zugewandten Kontaktschichtabschnitt (32) aufweist, wobei der Kontaktschichtabschnitt (32) einen höheren Brechungsindex hat, als der Schutzschichtabschnitt (31). Ferner betrifft die Erfindung ein Solarzellenherstellungsverfahren hierfür.

## Beschreibung

Die Erfindung betrifft eine Solarzelle und ein Solarzellenherstellungsverfahren.

Bei künftigen Solarzellen werden voraussichtlich dielektrische Passivierschichten auf der Rückseitenoberfläche ihres Halbleitersubstrats angeordnet, um Ladungsträgerrekombinationen an der Halbleiteroberfläche zu minimieren und hierdurch den Wirkungsgrad der Solarzelle zu erhöhen. Es ist eine Reihe von Materialien für Passivierschichten bekannt. Aus Sicht der Zelle hat insbesondere Aluminiumoxid das größte Potenzial, da sich an der Grenzfläche zwischen dem Halbleiter und dem Aluminiumoxid negative Ladungen bilden, welche durch den sich hieraus ausbildenden Feldeffekt auf p-Typ Material eine sogenannte Feldeffektpassivierung bewirken.

Nach der Passivierung muss zwecks Kontaktierung der Solarzelle eine Metallschicht auf die Passivierschicht der dielektrischen Passivierung erzeugt werden. Bei der in der industriellen Produktion gängigsten Kontaktierungsart für gegenwärtige Solarzellen, wird die Metallschicht mittels Metallpasten erzeugt, welche auf das Halbleitersubstrat aufgetragen und anschließend einer Wärmebehandlung unterzogen werden. Dieser Wärmebehandlungsschritt ist allgemein als Feuerschritt bekannt.

Hierbei ist es für die Langzeitstabilität der Solarzelle im fertigen Solarmodul wichtig, dass die Metallpaste gut auf die darunterliegende Passivierschicht haftet. Andererseits darf die Reaktion, welche die Haftung hervorruft, nicht zu aggressiv sein, um die Passivierung nicht zu beschädigen. Üblicherweise werden die Haftungseigenschaften der Metallschicht und die Reaktionsgeschwindigkeit beim Feuerschritt mittels geeigneter Auswahl des Anteils an Glasfritten in der Metallpaste eingestellt. Die Reaktionsgeschwindigkeit und Reaktionstiefe hängt aber auch wesentlich von der Art und Zusammensetzung des Materials der Passivierschicht ab. Hierbei ist das Prozessfenster zwischen dem Fall, dass die Metallpaste zu wenig aggressiv ist, also gar nicht haftet, und dem Fall, dass sie zu aggressiv ist, also die Passivierung zerstört, sehr schmal ist. Erschwert wird die Situation ferner dadurch, dass die Passivierschichten sehr dünn sein müssen, mit einer Schichtdicke von in der Regel um die 100 Nanometer. Außerdem wird der Reaktionshergang durch Inhomogenitäten im Dielektrikum beeinflusst, beispielsweise durch Pinholes, Einschlüssen (Blister), Bruchstellen (Cracks) oder dergleichen, oder durch Übergänge zwischen amorphen und kristallinen Bereichen.

Die Auswahl einer geeigneten Kombination an Passivierschicht-Material und Metallpasten-Material führt somit immer zu einem Kompromiss zwischen Passiviereigenschaften der Passivierschicht und der Haftungswirkung der Metallschicht. Zudem ist beispielsweise kein geeignetes Metallpasten-Material bekannt, welches Aluminiumoxid-Passivierschichten nicht angreift. Schließlich ist eine Erhöhung der Schichtdicke der Passivierschicht wirtschaftlich nicht sinnvoll, da qualitativ hochwertige Passivierschichten in der Regel auch sehr teuer sind.

Es ist Aufgabe der Erfindung, eine Solarzelle und ein Solarzellenherstellungsverfahren bereitzustellen, bei denen eine gute Haftung zwischen Passivierschicht und Metallschicht bei gleichzeitig guter Passivierungswirkung der Passivierschicht erzielt wird.

Die Aufgabe wird gemäß der Erfindung durch eine Solarzelle mit den Merkmalen des Anspruchs 1 und durch ein Solarzellenherstellungsverfahren mit den Merkmalen des Anspruchs 15 gelöst. Vorteilhafte Weiterbildungen der Erfindung sind in den Unteransprüchen aufgeführt.

Die Erfindung beruht auf der Überlegung, die Wirkung der Passivierung und die Haftungswirkung einer hierauf angeordneten Metallisierung voneinander zu trennen, um den oben beschriebenen Kompromisszwang zu umgehen. Hierzu wird eine Deckschicht auf die rückseitige Rückseitenpassivierschicht aufgebracht, welche zum einen die Rückseitenpassivierschicht schützt und zum anderen die Haftung beziehungsweise den Kontakt zwischen der Metallisierung und dem Halbleitersubstrat optimiert.

Es wurde durch die Erfinder herausgefunden, dass die Stabilität eines Schichtmaterials gegenüber einer Metallpaste bei einem Feuerschritt von Materialeigenschaften abhängen, welche in direkten Zusammenhang mit dem Brechungsindex stehen. Hierbei sind die Schichten mit einem niedrigeren Brechungsindex stabiler gegenüber der Metallpaste, während jene mit einem höherem Brechungsindex eine innigere Verbindung mit der hieraus entstehenden Metallschicht eingehen und somit eine bessere Haftung der Metallschicht auf dem Halbleitersubstrat ermöglichen. Somit kann der Schutzschichtabschnitt der Deckschicht, welcher der Rückseitenpassivierschicht zugewandt ist, so hergestellt sein, dass er einen niedrigen Brechungsindex hat und somit die Rückseitenpassivierschicht schützt. Gleichzeitig hat der Kontaktschichtabschnitt der Deckschicht, welche der Metallisierungsschicht zugewandt ist, einen höheren Brechungsindex und dient deshalb der besseren Haftung der Metallisierungsschicht.

Um eine derartige Solarzelle herzustellen, wird nach dem Aufbringen, vorzugsweise Abscheiden, einer Rückseitenpassivierschicht auf das Halbleitersubstrat, eine Deckschicht umfassend einen Schutzschichtabschnitt mit niedrigerem Brechungsindex und einen Kontaktschichtabschnitt mit verhältnismäßig höherem Brechungsindex aufgebracht. Anschließend wird die Metallisierungsschicht aufgebracht, vorzugsweise mittels Auftragen einer Metallpaste, beispielsweise einer aluminiumhaltigen Paste, und eines anschließenden Feuerschritt. Alternativ kann die Metallisierungsschicht mittels eines Abscheideverfahrens wie beispielsweise mittels physikalischer Abscheidung aus der Gasphase (physical vapor deposition - PVD) oder mittels eines anderen geeigneten Verfahrens hergestellt sein. Die Kontaktierung der Metallisierungsschicht mit dem Halbleitersubstrat erfolgt vorzugsweise mittels laserinduzierten Kontakten (sogenannten laser fired contacts - LFC), beispielsweise rasterförmig über das Halbleitersubstrat verteilt.

Nach dem Fertigstellen der Solarzelle weist die zwischen der Rückseitenpassivierschicht und der Metallisierungsschicht angeordnete Deckschicht somit einen der Rückseitenpassivierschicht zugewandten Schutzschichtabschnitt und einen der Metallisierungsschicht zugewandten Kontaktschichtabschnitt auf. Abhängig vom angewendeten Herstellungsverfahren, kann der Kontaktschichtabschnitt auf der gesamten Rückseitenoberfläche des Halbleitersubstrats vollständig oder teilweise erhalten sein. In bestimmten Ausführungsformen wird jedoch dieser Kontaktschichtabschnitt der Deckschicht sich derart mit der Metallisierungsschicht verbinden oder in der Metallschicht aufgehen, dass er in seiner Zusammensetzung teilweise oder (bezüglich seiner Dicke) vollständig umgeformt (umgewandelt) wird.

In jedem Fall wird jedoch die Deckschicht in der fertigen Solarzelle zumindest in Oberflächenbereichen den Kontaktschichtabschnitt aufweisen, nämlich beispielsweise in den Oberflächenbereichen, in denen die Metallisierungsschicht die Deckschicht nicht bedeckt oder in denen der Kontaktschichtabschnitt dick genug ausgebildet ist, dass die Reaktion zwischen ihm und der Metallisierungsschicht nicht vollständig durch die Dicke des Kontaktschichtabschnittes dringt. Hierbei kann es sich beispielsweise um Randbereiche der Rückseitenoberfläche des Halbleitersubstrats, zum Beispiel in Form eines Rahmens um die Rückseitenoberfläche, und / oder um Inselbereiche innerhalb der Rückseitenoberfläche des Halbleitersubstrats handeln.

Bei einer bevorzugten Ausführungsform ist vorgesehen, dass die Deckschicht aus zwei oder mehreren Teilschichten gebildet ist, wobei der Schutzschichtabschnitt und der Kontaktschichtabschnitt jeweils eine der Teilschichten sind. Hierbei wird zunächst eine Schutzschicht als Schutzschichtabschnitt der Deckschicht aufgebracht und hierauf eine Kontaktschicht als Kontaktschichtabschnitt der Deckschicht angeordnet. Es können auch weitere Zwischenschichten zwischen den beiden Abschnitten gebildet sein. Die Ausführungsform, bei der die Deckschicht aus Teilschichten gebildet ist, unterscheidet sich von dem graduellen Brechungsindexverlauf gemäß der nachfolgenden Ausführungsform dadurch, dass die Deckschicht einen eher stufenförmigen Brechungsindexverlauf aufweist.

In einer vorteilhaften Weiterbildung ist vorgesehen, dass die Deckschicht einen graduellen Brechungsindexverlauf aufweist, welcher von dem Schutzschichtabschnitt zu dem Kontaktschichtabschnitt ansteigt. Der Brechungsindexverlauf kann linear oder nicht-linear ansteigen. Hierzu können die Abscheidebedingungen und / oder die Ausgangsstoffe während der Abscheidung der Deckschicht graduell oder in kleinen Schritten geändert werden, um einen entsprechenden Brechungsindexgradienten in der Deckschicht zu erhalten.

Gemäß einer zweckmäßigen Ausgestaltung ist vorgesehen, dass der Schutzschichtabschnitt und der Kontaktschichtabschnitt jeweils einen Brechungsindex zwischen etwa 1,5 und 4,5 in dem Spektralbereich aufweisen, welcher der Arbeitsbereich der Solarzelle ist. Vorzugsweise hat der Schutzschichtabschnitt einen Brechungsindex von etwa 1.9, während der Kontaktschichtabschnitt einen Brechungsindex von etwa 2,05 hat. Bei einem graduellen Brechungsindexverlauf verändert sich dieser vorzugsweise zwischen 1,9 nahe der Rückseitenpassivierschicht und 2,05 nahe der Metallisierungsschicht. Die hier genannten Brechungsindexwerte gelten für den Arbeitsbereich der Solarzelle und können vorzugsweise im optischen und / oder infraroten Bereich des elektromagnetischen Spektrums gemessen sein, insbesondere bei einer Wellenlänge von etwa 630 Nanometern.

In bestimmten Ausführungsformen ist es vorteilhaft, wenn der Schutzschichtabschnitt einen Brechungsindex zwischen etwa 1,7 und 2,4 oder zwischen etwa 1,8 und 2,1 oder zwischen etwa 1,85 und 1,95 aufweist, während der Kontaktschichtabschnitt einen Brechungsindex zwischen etwa 1,5 und 4,5 oder zwischen etwa 1,8 und 2,8 oder zwischen etwa 3,5 und 4,5 aufweist. Die genauen Brechungsindexwerte können für den Schutzschichtabschnitt und den Kontaktschichtabschnitt unabhängig voneinander gewählt werden, solange der Kontaktschichtabschnitt einen höheren Brechungsindex aufweist, als der Schutzschichtabschnitt.

Bevorzugterweise ist vorgesehen, dass der Schutzschichtabschnitt und der Kontaktschichtabschnitt aus einer Stoffverbindung gebildet sind und der Brechungsindexunterschied zwischen dem Schutzschichtabschnitt und dem Kontaktschichtabschnitt auf unterschiedlichen stöchiometrischen Zusammensetzungen der Stoffe in der Stoffverbindung beruht. Dies kann bei der Solarzellenherstellung dadurch erzielt werden, dass bei der Abscheidung der Deckschicht das Mengenverhältnis der Ausgangsstoffe variiert wird. Beispielsweise können die Gasflüsse der Ausgangsstoffe bei Anwendung eines plasmaunterstützten Gasphasenabscheideverfahrens (PECVD - plasma enhanced physical vapor deposition) während der Abscheidung der Deckschicht schrittweise (bei mehreren Teilschichten) oder graduell (bei graduellem Brechungsindexverlauf) variiert werden.

Bei einer zweckmäßigen Ausführungsform ist vorgesehen, dass der Brechungsindexunterschied zwischen dem Schutzschichtabschnitt und dem Kontaktschichtabschnitt auf unterschiedlichen Wasserstoffgehältern in den beiden Abschnitten beruht. Mit anderen Worten, der Wasserstoffgehalt in den beiden Abschnitten der Deckschicht ist unterschiedlich. Hierbei sind der Schutzschichtabschnitt und der Kontaktschichtabschnitt vorzugsweise aus dem gleichen Material und bevorzugt sogar mit der gleichen stöchiometrischen Zusammensetzung gebildet. Alternativ können jedoch sowohl die stöchiometrische Zusammensetzung, als auch der Wasserstoffgehalt in den beiden Abschnitten derart eingestellt sein, dass sich die gewünschten Brechungsindices oder der gewünschte Brechungsindexverlauf bilden.

In einer vorteilhaften Ausgestaltung ist vorgesehen, dass die Deckschicht aus amorphem oder mikrokristallinem Silizium, aus Siliziumnitrid und / oder aus Siliziumoxinitrid gebildet ist. Um den Brechungsindex bei diesen Materialien zu variieren, können im Siliziumnitrid das Verhältnis zwischen Silizium und Stickstoff beziehungsweise im Siliziumoxinitrid das Verhältnis zwischen Siliziumnitrid und Sauerstoff in den jeweiligen Stoffverbindungen geändert werden. Anders ausgedrückt kann x in SiNx beziehungsweise in SiN(1-x)Ox variiert werden. Neben Sauerstoff können jedoch auch andere geeignete Stoffe in das Siliziumnitrid eingebaut werden, um den Brechungsindex zu steuern, beispielsweise Kohlenstoff.

Wenn die Metallisierungsschicht mittels Metallpastenauftragung und einem anschließenden Feuerschritt erzeugt wird, werden in der Regel Metallpasten eingesetzt, welche Glasfritten enthalten. Während des Feuerschrittes reagieren diese Glasfritten mit der unterhalb der Metallpaste liegenden Schicht und erzeugen eine sogenannte Eutektikumsschicht (beispielsweise bei Verwendung einer Al-Paste ein Al-Si-Eutektikum). Diese Eutektikumsschicht dient üblicherweise sowohl als Passivierungsschicht, als auch als Haftungsschicht für die Haftung der Metallisierungsschicht an der Solarzelle.

Insbesondere dann, wenn der Kontaktschichtabschnitt der Deckschicht Silizium enthält, können für die Rückseitenmetallisierung Metallpasten verwendet werden, welche keine Glasfritten enthalten. Bei einem nachfolgenden Feuerschritt reagiert dann die Metallpaste mit dem Silizium des Kontaktschichtabschnittes, sodass auch hier eine Eutektikumsschicht gebildet wir. In diesem Prozess wird das Silizium teilweise oder vollständig umgewandelt. Gemäß einer bevorzugten Ausgestaltung enthalten daher der Schutzschichtabschnitt der Deckschicht Siliziumnitrid und der Kontaktschichtabschnitt der Deckschicht amorphes oder mikrokristallines Silizium.

Gemäß einer bevorzugten Weiterbildung ist vorgesehen, dass die Rückseitenpassivierschicht aus Aluminiumoxid gebildet ist. Eine derartige Aluminiumoxidschicht, beispielsweise im stöchiometrischen Verhältnis Al2O3, wird vorzugsweise mittels Atomlagenabscheidung (ALD - atomic layer deposition), PECVD oder PVD aufgebracht. Die Rückseitenpassivierschicht aus Aluminiumoxid weist vorzugsweise eine Schichtdicke von unter 100 Nanometern auf, bevorzugt eine Schichtdicke von etwa 30 Nanometern, besonders bevorzugt 10 Nanometer.

Vorteilhafterweise ist vorgesehen, dass die Rückseitenpassivierschicht unmittelbar auf dem Halbleitersubstrat, die Deckschicht unmittelbar auf der Rückseitenpassivierschicht und / oder die Metallisierungsschicht unmittelbar auf der Deckschicht gebildet sind. Die unmittelbare Anordnung bedeutet, dass zwischen den betreffenden Schichten keine weitere Zwischenschicht angeordnet ist. Alternativ kann jedoch, beispielsweise prozessbedingt, vor oder während dem Aufbringen der Rückseitenpassivierschicht eine dünne Oxidschicht auf dem Halbleitersubstrat als Zwischenschicht zwischen dem Halbleitersubstrat und der Rückseitenpassivierschicht entstehen.

Gemäß einer bevorzugten Ausgestaltung ist vorgesehen, dass die Deckschicht im Wesentlichen die gesamte Rückseitenoberfläche des Halbleitersubstrats bedeckt. Im Wesentlichen bedeutet in diesem Fall, dass prozessbedingt Bereiche des Halbleitersubstrats, insbesondere Randbereiche, vorliegen können, welche nicht von der Deckschicht bedeckt sind. Vorzugsweise bedeckt die Deckschicht mindestens 90%, bevorzugt mindestens 95% oder 99% der Rückseitenoberfläche des Halbleitersubstrats. Die gemäß der Ausführungsform in diesem Absatz aufgeführten Merkmale betreffend die Deckschicht gelten entsprechend auch für den Schutzschichtabschnitt und den Kontaktschichtabschnitt, wobei jedoch, wie vorangehend erläutert, der Kontaktschichtabschnitt in bestimmten Ausführungsformen lediglich in Oberflächenbereichen vorliegen kann. Diese Oberflächenbereiche können beispielsweise mindesten etwa 0,5%, 3% oder 10% der Rückseitenoberfläche des Halbleitersubstrats umfassen.

Die Oberflächenbereiche, in denen der Kontaktschichtabschnitt nicht mehr oder nur noch zum Teil in seiner ursprünglichen Schichtdicke vorliegt sind z.B. die Bereiche, in denen die Metallisierungsschicht während des Feuerns die Kontaktschicht "auffrisst". An den Zellrändern, auf die keine Paste gedruckt wird, ist auch nach dem Feuern noch die komplette Deckschicht vorhanden. Wird die Paste bis sehr nahe an den Zellrand gedruckt wird dieser Flächenanteil sehr klein

Bevorzugterweise ist eine beidseitige Kontaktierung vorgesehen. Das bedeutet, dass die Solarzelle sowohl auf der Lichteinfallseite (Vorderseite) als auch auf der lichtabgewandten Rückseite eine Metallisierung aufweist. Auf der Vorderseite ist die Metallisierung vorzugsweise mittels streifenförmiger Kontaktelektroden oder mittels eines Kontaktgitters verwirklicht.

In einer zweckmäßigen Weiterbildung ist vorgesehen, dass die Rückseitenpassivierschicht und die Deckschicht zusammen ein Reflexionsschichtsystem für den Spektralbereich bilden, welcher der Arbeitsbereich der Solarzelle ist. Mit anderen Worten, sind die optischen Eigenschaften der Rückseitenpassivierschicht und der Deckschicht derart aufeinander abgestimmt, dass sie durch das Halbleitersubstrat dringendes Licht reflektieren. Wie vorangehend in Zusammenhang mit dem Brechungsindexwerten erläutert, liegt der hier genannte spektrale Arbeitsbereich der Solarzelle vorzugsweise im sichtbaren und / oder infraroten Bereich.

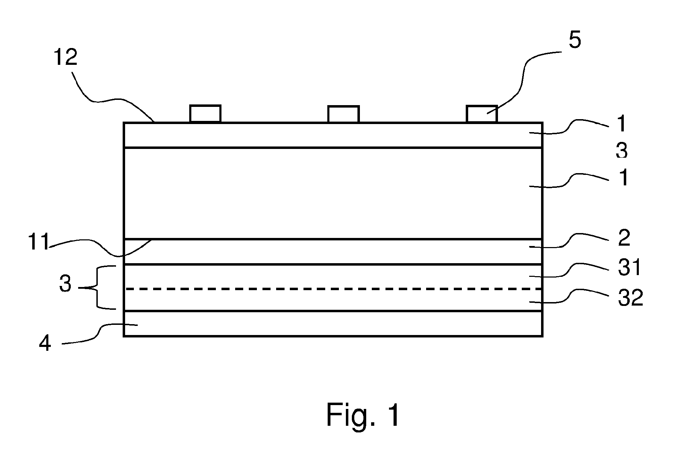

Die Erfindung wird im Folgenden anhand von Ausführungsbeispielen unter Bezugnahme auf eine Figur erläutert. Hierbei zeigt die einzige Figur eine beidseitig kontaktierte Solarzelle mit einer Rückseitenpassivierschicht und einer hierauf angeordneten Deckschicht.

In der Figur wird eine Solarzelle mit einem Halbleitersubstrat 1 dargestellt. Entlang einer Vorderseitenoberfläche 12, welche beim Betrieb der Solarzelle dem einfallenden Licht zugewandt ist, ist in dem Halbleitersubstrat 1 eine Emitterschicht 13 mittels Dotierung gebildet. Wenn beispielsweise das Halbleitersubstrat 1 zunächst ein n-Typ Halbleiter umfasst, kann mittels Dotierung ein p-Typ Emitter 13 ausgebildet werden. Die Emitterschicht 13 wird mittels hierauf angeordneter Vorderseitenelektroden 5 kontaktiert.

Auf einer Rückseitenoberfläche 11 des Halbleitersubstrats 1 ist eine Rückseitenpassivierschicht 2 angeordnet. Sie dient der Passivierung der Rückseitenoberfläche 11. Auf der Rückseitenpassivierschicht 2 ist eine Deckschicht 3 angeordnet, welche zugleich die Rückseitenpassivierschicht 2 schützt und die Haftung einer hierauf angeordneten Metallisierungsschicht 4 verbessert.

Hierzu weist die Deckschicht 3 einen der Rückseitenpassivierschicht 2 zugewandten Schutzschichtabschnitt 31 und einen der Metallisierungsschicht 4 zugewandten Kontaktschichtabschnitt 32 auf. Der Schutzschichtabschnitt 31 weist einen niedrigeren Brechungsindex auf, beispielsweise von etwa 1,9. Demgegenüber weist der Kontaktschichtabschnitt 32 einen höheren Brechungsindex auf, beispielsweise von etwa 2,05 oder 3,5.

Der Schutzschichtabschnitt 31 und der Kontaktschichtabschnitt 32 bilden in der hier dargestellten Ausführungsform jeweils eine separate Teilschicht der Deckschicht 3, zwischen denen gegebenenfalls weitere Zwischenschichten (in der Figur nicht dargestellt) mit Brechungsindexwerten zwischen denen der beiden Abschnitte 31, 32 angeordnet sein können. Alternativ kann es sich bei dem Schutzschichtabschnitt 31 und dem Kontaktschichtabschnitt 32 um Abschnitte einer Deckschicht 3 mit einem graduellen Brechungsindexverlauf handeln. Der graduelle Brechungsindexverlauf kann hierbei linear oder auf eine andere geeignete Weise von dem Schutzschichtabschnitt 31 zu dem Kontaktschichtabschnitt 32 hin ansteigen.

### Bezugszeichenliste:

- 1: Halbleitersubstrat
- 11: Rückseitenoberfläche
- 12: Vorderseitenoberfläche
- 13: Emitterschicht

- 2: Rückseitenpassivierschicht

- 3: Deckschicht
- 31: Schutzschichtabschnitt
- 32: Kontaktschichtabschnitt

- 4: Metallisierungsschicht

- 5: Vorderseitenelektroden

## Patentansprüche

1. Solarzelle mit einem Halbleitersubstrat (1), einer auf einer lichtabgewandten Rückseitenoberfläche (11) des Halbleitersubstrats (1) angeordneten Rückseitenpassivierschicht (2), einer auf der Rückseitenpassivierschicht (2) angeordneten Deckschicht (3) und einer auf der Deckschicht (3) angeordneten Metallisierungsschicht (4), **dadurch gekennzeichnet, dass** die Deckschicht (3) einen der Rückseitenpassivierschicht (2) zugewandten Schutzschichtabschnitt (31) und zumindest in Oberflächenbereichen einen der Metallisierungsschicht (4) zugewandten Kontaktschichtabschnitt (32) aufweist, wobei der Kontaktschichtabschnitt (32) einen höheren Brechungsindex hat, als der Schutzschichtabschnitt (31).

2. Solarzelle nach Anspruch 1, **dadurch gekennzeichnet, dass** die Deckschicht (3) aus zwei oder mehreren Teilschichten (31, 32) gebildet ist, wobei der Schutzschichtabschnitt (31) und der Kontaktschichtabschnitt (32) jeweils eine der Teilschichten (31, 32) sind.

3. Solarzelle nach Anspruch 1, **dadurch gekennzeichnet, dass** die Deckschicht (3) einen graduellen Brechungsindexverlauf aufweist, welcher von dem Schutzschichtabschnitt (31) zu dem Kontaktschichtabschnitt (32) ansteigt.

4. Solarzelle nach einem der vorangehenden Ansprüche, **dadurch gekennzeichnet, dass** der Schutzschichtabschnitt (31) und der Kontaktschichtabschnitt (32) jeweils einen Brechungsindex zwischen etwa 1,5 und 4,5 in dem Spektralbereich aufweisen, welcher der Arbeitsbereich der Solarzelle ist.

5. Solarzelle nach Anspruch 4, **dadurch gekennzeichnet, dass** der Schutzschichtabschnitt (31) einen Brechungsindex zwischen etwa 1,7 und 2,4 oder 1,8 und 2,1 oder 1,85 und 1,95 und der Kontaktschichtabschnitt (32) einen Brechungsindex zwischen etwa 1,5 und 4,5 oder 1,8 und 2,8 oder 3,5 und 4,5 aufweisen.

6. Solarzelle nach einem der vorangehenden Ansprüche, **dadurch gekennzeichnet, dass** der Schutzschichtabschnitt (31) und der Kontaktschichtabschnitt (32) aus einer Stoffverbindung gebildet sind und der Brechungsindexunterschied zwischen dem Schutzschichtabschnitt (31) und dem Kontaktschichtabschnitt (32) auf unterschiedlichen stöchiometrischen Zusammensetzungen der Stoffe in der Stoffverbindung beruht.

7. Solarzelle nach einem der vorangehenden Ansprüche, **dadurch gekennzeichnet, dass** der Brechungsindexunterschied zwischen dem Schutzschichtabschnitt (31) und dem Kontaktschichtabschnitt (32) auf unterschiedlichen Wasserstoffgehalten in den beiden Abschnitten (31, 32) beruht.

8. Solarzelle nach einem der vorangehenden Ansprüche, **dadurch gekennzeichnet, dass** die Deckschicht (3) aus amorphem oder mikrokristallinem Silizium, aus Siliziumnitrid und / oder aus Siliziumoxinitrid gebildet ist.

9. Solarzelle nach einem der vorangehenden Ansprüche, **dadurch gekennzeichnet, dass** der Schutzschichtabschnitt (31) der Deckschicht (3) Siliziumnitrid und / oder der Kontaktschichtabschnitt (32) der Deckschicht (3) amorphes oder mikrokristallines Silizium enthalten.

10. Solarzelle nach einem der vorangehenden Ansprüche, **dadurch gekennzeichnet, dass** die Rückseitenpassivierschicht (2) aus Aluminiumoxid, amorphen Silizium, amorphem Siliziumnitrid oder amorphem Siliziumoxid gebildet ist.

11. Solarzelle nach einem der vorangehenden Ansprüche, **dadurch gekennzeichnet, dass** die Rückseitenpassivierschicht (2) unmittelbar auf dem Halbleitersubstrat (1), die Deckschicht (3) unmittelbar auf der Rückseitenpassivierschicht (2) und / oder die Metallisierungsschicht (4) unmittelbar auf der Deckschicht (3) gebildet sind.

12. Solarzelle nach einem der vorangehenden Ansprüche, **dadurch gekennzeichnet, dass** die Deckschicht (3) im Wesentlichen die gesamte Rückseitenoberfläche (11) des Halbleitersubstrats (1) bedeckt.

13. Solarzelle nach einem der vorangehenden Ansprüche, **gekennzeichnet durch** eine beidseitige Kontaktierung.

14. Solarzelle nach einem der vorangehenden Ansprüche, **dadurch gekennzeichnet, dass** die Rückseitenpassivierschicht (2) und die Deckschicht (3) zusammen ein Reflexionsschichtsystem für den Spektralbereich bilden, welcher der Arbeitsbereich der Solarzelle ist.

15. Solarzellenherstellungsverfahren umfassend die folgenden Schritte:
- Bereitstellen eines Halbleitersubstrats (1);
- Aufbringen einer Rückseitenpassivierschicht (2) auf eine lichtabgewandte Rückseitenoberfläche (11) des Halbleitersubstrats (1);
- Aufbringen einer Deckschicht (3) auf die Rückseitenpassivierschicht (2); und
- Aufbringen einer Metallisierungsschicht (4) auf die Deckschicht (3), wobei die Deckschicht (3) mit einer der Rückseitenpassivierschicht (2) zugewandten Schutzschichtabschnitt (31) und einer der Metallisierungsschicht (4) zugewandten Kontaktschichtabschnitt (32) derart aufgebracht wird, dass der Kontaktschichtabschnitt (32) einen höheren Brechungsindex hat, als der Schutzschichtabschnitt (31).
